# EUROPEAN PATENT APPLICATION

(11) **EP 4 783 780 A1**
(43) Date of publication of application: **29.07.2026**
(21) Application number: 26152838.4
(22) Date of filing: 20.01.2026
(51) Int. Cl.: H10F 30/223, G02B 6/12, H10F 77/1226

(54) **PHOTODIODE AND ELECTRONIC DEVICE INCLUDING THE SAME**

(30) Priority: 23.01.2025 KR 20250010661
(71) Applicant: Samsung Electronics Co., Ltd., Suwon-si, Gyeonggi-do 16677 (KR)
(72) Inventor: BAIK, Chanwook, 16677 Suwon-si (KR); YOON, Youngzoon, 16678 Suwon-si (KR); CHO, Kyungsang, 16677 Suwon-si (KR)
(74) Representative: Arnold & Siedsma

(57) **Abstract**

An optical sensing element may include: a substrate; a first silicon semiconductor layer on the substrate in a first direction; a second silicon semiconductor layer on the substrate in the first direction, and spaced apart from the second silicon semiconductor layer in the first direction; and a germanium semiconductor layer between the first silicon semiconductor layer and the second silicon semiconductor layer, the germanium semiconductor layer comprising germanium, wherein the first silicon semiconductor layer comprises: a first region comprising an intrinsic silicon semiconductor, a second region comprising a silicon semiconductor doped with a first conductivity type dopant, and wherein the germanium semiconductor layer comprises an intrinsic germanium semiconductor, and an entirety of the intrinsic germanium semiconductor of the germanium semiconductor layer does not include a dopant.

## Description

### BACKGROUND

### 1. Field

The disclosure relates to a photodiode and an electronic device including the same.

### 2. Description of Related Art

Photodiodes or photosensors may utilize silicon-based P-N junction technology that operates in the visible light band. This structure is used in various types of Complementary Metal-Oxide-Semiconductor (CMOS) image sensors because silicon has a high absorption rate for light in the visible light band, excellent photocurrent linearity, high quantum efficiency (~80%), and low noise, and the price of silicon is also low.

Photodiodes utilizing silicon P-N junctions may not absorb photons having energy lower than the silicon bandgap energy (~1.12 eV). Therefore, silicon photodiodes or silicon CMOS image sensors using them are mainly used in cameras for visible light (e.g., 400 nm to 700 nm).

For optical devices that sense light in a near infrared (e.g., 700 nm to 1,600 nm) band, which has a longer wavelength than visible light, semiconductor materials with lower bandgap energy than silicon must be used. However, when manufacturing an optical sensor by forming a semiconductor material that exhibits lattice mismatch with a silicon material on a silicon substrate, the quality of the optical sensor deteriorates due to noise generation caused by dark current.

### SUMMARY

Provided are an optical sensing element for sensing light in an infrared band and an electronic device including the same.

According to an aspect of the disclosure, an optical sensing element may include: a substrate; a first silicon semiconductor layer on the substrate in a first direction; a second silicon semiconductor layer on the substrate in the first direction, and spaced apart from the first silicon semiconductor layer in the first direction; and a germanium semiconductor layer between the first silicon semiconductor layer and the second silicon semiconductor layer, the germanium semiconductor layer comprising germanium, wherein the first silicon semiconductor layer comprises: a first region comprising an intrinsic silicon semiconductor, a second region comprising a silicon semiconductor doped with a first conductivity type dopant, and wherein the germanium semiconductor layer comprises an intrinsic germanium semiconductor, and an entirety of the intrinsic germanium semiconductor of the germanium semiconductor layer does not include a dopant.

The first region may be in contact with the germanium semiconductor layer in the first direction, and the second silicon semiconductor layer may be between the substrate and the germanium semiconductor layer.

The second silicon semiconductor layer may be doped with a second conductivity type dopant, which may be opposite to a conductivity type of the first conductivity type dopant.

The optical sensing element may further include: a first conductive layer on the first silicon semiconductor layer and comprising a conductive material, wherein the second region is between the first region and the first conductive layer, and the second region is in contact with the first conductive layer.

A width of the second region in a second direction crossing the first direction may be less than a width of the germanium semiconductor layer in the second direction.

A thickness of the second region in the first direction may be less than or equal to a total thickness of the first silicon semiconductor layer in the first direction.

According to an aspect of the disclosure, the thickness of the second region may be 50 % to 100 % of the total thickness of the first silicon semiconductor layer.

The second silicon semiconductor layer may include: a first region in contact with the germanium semiconductor layer; and a second region adjacent to the first region of the second silicon semiconductor layer, the second region of the second silicon semiconductor layer having a higher doping concentration than a doping concentration of the first region of the second silicon semiconductor layer.

The optical sensing element may further include: a second conductive layer in contact with the second region of the second silicon semiconductor layer in the first direction, the second conductive layer comprising a conductive material.

The second silicon semiconductor layer may include an intrinsic silicon semiconductor layer.

The first silicon semiconductor layer may further include a third region comprising a silicon semiconductor doped with a second conductivity type dopant having a conductivity type opposite to a conductivity type of the first conductivity type dopant.

The optical sensing element may further include: a first conductive layer on the first silicon semiconductor layer in the first direction; a second conductive layer on the first silicon semiconductor layer in the first direction, the second conductive layer spaced apart from the first conductive layer in a second direction crossing the first direction, wherein each of the first conductive layer and the second conductive layer comprises a conductive material, wherein the second region is in contact with the first conductive layer, and is between the first conductive layer and the first region, and wherein the third region is in contact with the second conductive layer, and is between the second conductive layer and the first region.

A thickness of the second region in the first direction and a thickness of the third region in the first direction are less than or equal to a thickness of the first silicon semiconductor layer in the first direction.

The first silicon semiconductor layer may be between the substrate and the germanium semiconductor layer, and the second silicon semiconductor layer may be on the germanium semiconductor layer.

The first silicon semiconductor layer may further include a third region doped with a second conductivity type dopant, wherein a conductivity type of the second conductivity type dopant is opposite to a conductivity type of the first conductivity type dopant, and the first region may be between the second region and the third region in a second direction crossing the first direction.

The first silicon semiconductor layer may further include: a fourth region adjacent to the second region and doped with the first conductivity type dopant at a higher concentration than a doping concentration of the second region; and a fifth region adjacent to the third region and doped with the second conductivity type dopant at a higher concentration than a doping concentration of the third region.

The first silicon semiconductor layer or the second silicon semiconductor layer may form a part of an optical waveguide extending in a direction crossing to the first direction.

According to an aspect of the disclosure, an optical integrated circuit may include: an optical waveguide; and an optical sensing element configured to couple light traveling along the optical waveguide to generate an electrical signal corresponding to the light, wherein the optical sensing element comprises: a substrate; a first silicon semiconductor layer on the substrate in a first direction; a second silicon semiconductor layer on the substrate in the first direction, and spaced apart from the second silicon semiconductor layer in the first direction; and a germanium semiconductor layer between the first silicon semiconductor layer and the second silicon semiconductor layer, the germanium semiconductor layer comprising germanium, wherein the first silicon semiconductor layer comprises: a first region comprising an intrinsic silicon semiconductor; and a second region comprising a silicon semiconductor doped with a first conductivity type dopant, and wherein the germanium semiconductor layer comprises an intrinsic germanium semiconductor, and an entirety of the intrinsic germanium semiconductor of the germanium semiconductor layer does not include a dopant.

According to an aspect of the disclosure, an electronic device may include: a processor package comprising an optical integrated circuit and a processor; an input interface electrically connected to the processor package; and an output interface electrically connected to the processor package, wherein the optical integrated circuit comprises the optical sensing element.

According to an aspect of the disclosure, a method of manufacturing an optical sensing element may include: forming an intrinsic germanium semiconductor layer on a substrate; forming a silicon semiconductor layer that covers an entire upper surface of the intrinsic germanium semiconductor layer; forming a doped silicon semiconductor region in the silicon semiconductor layer by injecting a dopant into the silicon semiconductor layer, wherein the doped silicon semiconductor region has a thickness from an upper surface of the silicon semiconductor layer, and the thickness of the doped silicon semiconductor region is less than an entire thickness of the silicon semiconductor layer; and forming a conductive layer, wherein the conductive layer is in contact with the doped silicon semiconductor region.

The present disclosure may further relate to the aspects according to the following clauses:
1. An optical sensing element comprising:
   a substrate;
   a first silicon semiconductor layer on the substrate in a first direction;
   a second silicon semiconductor layer on the substrate in the first direction, and spaced apart from the second silicon semiconductor layer in the first direction; and
   a germanium semiconductor layer between the first silicon semiconductor layer and the second silicon semiconductor layer, the germanium semiconductor layer comprising germanium,
   wherein the first silicon semiconductor layer comprises:
      a first region comprising an intrinsic silicon semiconductor,
      a second region comprising a silicon semiconductor doped with a first conductivity type dopant, and
   wherein the germanium semiconductor layer comprises an intrinsic germanium semiconductor, and
   an entirety of the intrinsic germanium semiconductor of the germanium semiconductor layer does not include a dopant.
2. The optical sensing element of clause 1, wherein
   the first region is in contact with the germanium semiconductor layer in the first direction, and
   the second silicon semiconductor layer is between the substrate and the germanium semiconductor layer.
3. The optical sensing element of clause 2, wherein the second silicon semiconductor layer is doped with a second conductivity type dopant, which is opposite to a conductivity type of the first conductivity type dopant.
4. The optical sensing element of clause 3, further comprising:
   a first conductive layer on the first silicon semiconductor layer and comprising a conductive material,
   wherein the second region is between the first region and the first conductive layer, and the second region is in contact with the first conductive layer.
5. The optical sensing element of clause 4, wherein a width of the second region in a second direction crossing the first direction is less than a width of the germanium semiconductor layer in the second direction.
6. The optical sensing element of clause 4, wherein a thickness of the second region in the first direction is less than or equal to a total thickness of the first silicon semiconductor layer in the first direction.
7. The optical sensing element of clause 6, wherein the thickness of the second region is 50 % to 100 % of the total thickness of the first silicon semiconductor layer.
8. The optical sensing element of clause 4, wherein the second silicon semiconductor layer comprises:
   a first region in contact with the germanium semiconductor layer; and
   a second region adjacent to the first region of the second silicon semiconductor layer, the second region of the second silicon semiconductor layer having a higher doping concentration than a doping concentration of the first region of the second silicon semiconductor layer.
9. The optical sensing element of clause 8, further comprising:
   a second conductive layer in contact with the second region of the second silicon semiconductor layer in the first direction, the second conductive layer comprising a conductive material.
10. The optical sensing element of clause 2, wherein the second silicon semiconductor layer comprises an intrinsic silicon semiconductor layer.
11. The optical sensing element of clause 10, wherein
   the first silicon semiconductor layer further comprises a third region comprising a silicon semiconductor doped with a second conductivity type dopant having a conductivity type opposite to a conductivity type of the first conductivity type dopant.
12. The optical sensing element of clause 11, further comprising:
   a first conductive layer on the first silicon semiconductor layer in the first direction;
   a second conductive layer on the first silicon semiconductor layer in the first direction, the second conductive layer spaced apart from the first conductive layer in a second direction crossing the first direction,
   wherein each of the first conductive layer and the second conductive layer comprises a conductive material,
   wherein the second region is in contact with the first conductive layer, and is between the first conductive layer and the first region, and
   wherein the third region is in contact with the second conductive layer, and is between the second conductive layer and the first region.
13. The optical sensing element of clause 12, wherein a thickness of the second region in the first direction and a thickness of the third region in the first direction are less than or equal to a thickness of the first silicon semiconductor layer in the first direction.
14. The optical sensing element of any one of the previous clauses, wherein
   the first silicon semiconductor layer is between the substrate and the germanium semiconductor layer, and
   the second silicon semiconductor layer is on the germanium semiconductor layer.
15. The optical sensing element of any one of the previous clauses, wherein
   the first silicon semiconductor layer further comprises a third region doped with a second conductivity type dopant, wherein a conductivity type of the second conductivity type dopant is opposite to a conductivity type of the first conductivity type dopant, and
   the first region is between the second region and the third region in a second direction crossing the first direction.
16. The optical sensing element of clause 15, wherein the first silicon semiconductor layer further comprises:
   a fourth region adjacent to the second region and doped with the first conductivity type dopant at a higher concentration than a doping concentration of the second region; and
   a fifth region adjacent to the third region and doped with the second conductivity type dopant at a higher concentration than a doping concentration of the third region.
17. The optical sensing element of any one of the previous clauses, wherein
   the first silicon semiconductor layer or the second silicon semiconductor layer forms a part of an optical waveguide extending in a direction crossing to the first direction.
18. An optical integrated circuit comprising:
   an optical waveguide; and
   an optical sensing element configured to couple light traveling along the optical waveguide to generate an electrical signal corresponding to the light,
   wherein the optical sensing element comprises:
      a substrate;
      a first silicon semiconductor layer on the substrate in a first direction;
      a second silicon semiconductor layer on the substrate in the first direction, and spaced apart from the second silicon semiconductor layer in the first direction; and
      a germanium semiconductor layer between the first silicon semiconductor layer and the second silicon semiconductor layer, the germanium semiconductor layer comprising germanium, wherein the first silicon semiconductor layer comprises:
         a first region comprising an intrinsic silicon semiconductor; and
         a second region comprising a silicon semiconductor doped with a first conductivity type dopant, and
   wherein the germanium semiconductor layer comprises an intrinsic germanium semiconductor, and
   an entirety of the intrinsic germanium semiconductor of the germanium semiconductor layer does not include a dopant.
19. An electronic device comprising:
   a processor package comprising an optical integrated circuit and a processor;
   an input interface electrically connected to the processor package; and
   an output interface electrically connected to the processor package,
   wherein the optical integrated circuit comprises the optical sensing element of clause 1.
20. A method of manufacturing an optical sensing element, comprising:
   forming an intrinsic germanium semiconductor layer on a substrate;
   forming a silicon semiconductor layer that covers an entire upper surface of the intrinsic germanium semiconductor layer;
   forming a doped silicon semiconductor region in the silicon semiconductor layer by injecting a dopant into the silicon semiconductor layer, wherein the doped silicon semiconductor region has a thickness from an upper surface of the silicon semiconductor layer, and the thickness of the doped silicon semiconductor region is less than an entire thickness of the silicon semiconductor layer; and forming a conductive layer, wherein the conductive layer is in contact with the doped silicon semiconductor region.

Additional aspects will be set forth in part in the description which follows and, in part, will be apparent from the description, or may be learned by practice of the example embodiments of the disclosure.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1 is a schematic cross-sectional view showing a structure of an optical sensing element according to an embodiment;
FIG. 2 is a schematic cross-sectional view showing a structure of an optical sensing element according to an embodiment;
FIG. 3 is a schematic cross-sectional view showing a structure of an optical sensing element according to an embodiment;
FIG. 4 is a schematic cross-sectional view showing a structure of an optical sensing element according to an embodiment;
FIG. 5 is a schematic cross-sectional view showing a structure of an optical sensing element according to an embodiment;
FIG. 6 is a schematic cross-sectional view showing a structure of an optical sensing element according to an embodiment;
FIG. 7 is a schematic cross-sectional view showing a structure of an optical sensing element according to a comparative example;
FIG. 8A is a graph comparing dark currents of an optical sensing element according to an embodiment and an optical sensing element according to a comparative example;
FIG. 8B is a graph showing an enlarged portion of FIG. 8A;
FIG. 9A is a graph comparing the photocurrent of an optical sensing element according to an embodiment and an optical sensing element according to a comparative example;
FIG. 9B is graph showing an enlarged portion of FIG. 9A;
FIG. 10 is a schematic cross-sectional view showing a structure of an optical sensing element according to an embodiment;
FIG. 11 is a schematic cross-sectional view showing a structure of an optical sensing element according to an embodiment;
FIG. 12 is a schematic cross-sectional view showing a structure of an optical sensing element according to an embodiment;
FIG. 13 is a schematic cross-sectional view showing a structure of an optical sensing element according to an embodiment;
FIG. 14 is a schematic perspective view showing a structure of an optical integrated circuit according to an embodiment;
FIG. 15 is a flowchart for explaining a method of manufacturing an optical sensing element, according to an embodiment;
FIG. 16 is a block diagram showing a schematic structure of an optical integrated circuit according to an embodiment; and
FIG. 17 is a block diagram showing a schematic structure of an electronic device according to an embodiment.

### DETAILED DESCRIPTION

Reference will now be made in detail to non-limiting example embodiments of the disclosure, examples of which are illustrated in the accompanying drawings, wherein like reference numerals refer to like elements throughout. In this regard, embodiments of the disclosure are capable of various modifications, may have different forms, and should not be construed as being limited to the descriptions set forth herein. Accordingly, example embodiments are merely described below, by referring to the figures, to explain example aspects of the disclosure. As used herein, the term "and/or" includes any and all combinations of one or more of the associated listed items. Expressions such as "at least one of," when preceding a list of elements, modify the entire list of elements and do not modify the individual elements of the list. In the drawings, the sizes of elements in the drawings may be exaggerated for clarity and convenience of explanation.

When an element or layer is referred to as being "on" or "above" another element or layer, the element or layer may be directly on another element or layer or intervening elements or layers.

The terms "first," "second," etc. may be used herein to describe various elements, these elements are only used to distinguish one constituent element from another. These terms do not limit the material or structure of the components.

The singular forms are intended to include the plural forms unless the context clearly indicates otherwise. When a part "comprises" or "includes" an element in the specification, unless otherwise defined, other elements are not excluded from the part and the part may further include other elements.

Also, in the specification, the term "units" or "modules" denote units or modules that process at least one function or operation, and may be realized by hardware, software, or a combination of hardware and software.

The term "above" and similar directional terms may be applied to both singular and plural.

Operations of all methods described herein may be performed in any suitable order unless otherwise indicated herein or otherwise clearly contradicted by context. The use of any and all example languages (e.g., "such as") provided herein is intended merely to better illuminate example aspects of the disclosure and does not pose a limitation on the scope of the disclosure unless otherwise stated.

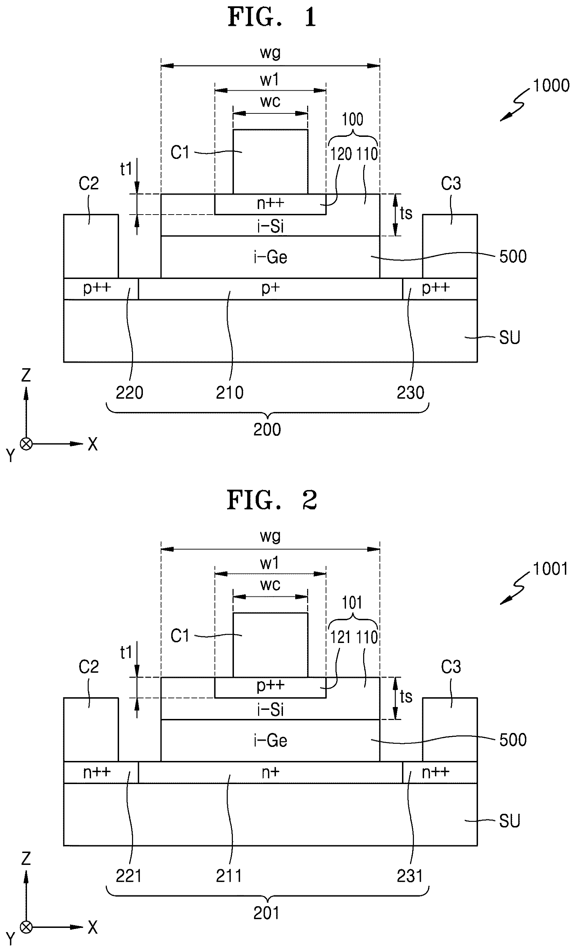

FIG. 1 is a schematic cross-sectional view showing the structure of an optical sensing element 1000 according to an embodiment.

The optical sensing element 1000 may include a substrate SU, and a second silicon semiconductor layer 200, a germanium semiconductor layer 500, and a first silicon semiconductor layer 100 disposed on the substrate SU. The germanium semiconductor layer 500 may be disposed between the first silicon semiconductor layer 100 and the second silicon semiconductor layer 200. The optical sensing element 1000 may also include a first conductive layer C1 disposed on the first silicon semiconductor layer 100, and a second conductive layer C2 and a third conductive layer C3 spaced apart from each other on the second silicon semiconductor layer 200.

The substrate SU may include an insulating material. The substrate SU may include a semiconductor material. An upper region of the substrate SU, that is, a region in contact with the second silicon semiconductor layer 200, may include an insulating material. The substrate SU may be a part of a layer forming a silicon on insulator (SOI) substrate. For example, among a lower silicon layer, a silicon oxide layer, and an upper silicon layer forming the SOI substrate, the upper silicon layer may be processed into the second silicon semiconductor layer 200, and the substrate SU may include the lower silicon layer and the silicon oxide layer. However, this is an example and the disclosure is not limited thereto.

The first silicon semiconductor layer 100 may be a layer protecting the germanium semiconductor layer 500. The first silicon semiconductor layer 100 may include a first region 110 including an intrinsic silicon semiconductor, and a second region 120 including a silicon semiconductor doped with a first conductivity type dopant. The first conductivity type dopant may be an n-type dopant. The n-type dopant may be P, As, Sb, or Bi, etc.

The first silicon semiconductor layer 100 may be arranged on the germanium semiconductor layer 500 so that the first region 110 is in contact with the germanium semiconductor layer 500. In the drawing, a width of the first region 110 is shown to be the same as a width of the germanium semiconductor layer 500, but this is an example, and the first region 110 may have a width that is greater or less than the width of the germanium semiconductor layer 500, such that the first region 110 covers an entirety of an upper surface of the germanium semiconductor layer 500 and extends past at least one side surface of the germanium semiconductor layer 500, or covers only a partial portion of the upper surface of the germanium semiconductor layer 500.

The second region 120 may be located between the first region 110 and the first conductive layer C1, and may be arranged in contact with the first conductive layer C1. The second region 120 and the first conductive layer C1 may form an ohmic junction structure. The second region 120 performs as a high-concentration doping region for electrical contact with the first conductive layer C1, and a width w1 and thickness t1 of the second region 120 may be appropriately provided so that no defect occurs in the germanium semiconductor layer 500 during a doping process. In the following description, the thickness denotes a thickness in a stacking direction, that is, a first direction (e.g., Z direction) away from the substrate SU, and the width denotes a width in a direction (e.g., X direction) perpendicular to the first direction (e.g., Z direction). The description of the width may be similarly applied to a width in a Y direction.

The width w1 of the second region 120 may be less than a width wg of the germanium semiconductor layer 500. The width w1 of the second region 120 may be less than the width wg of the first silicon semiconductor layer 100. In the drawing, the width wg of the germanium semiconductor layer 500 is shown to be constant in the Z direction, but this is an example and the width wg of the germanium semiconductor layer 500 may have a shape that has a width that decreases in the Z direction. In this case, the width wg of the germanium semiconductor layer 500 refers to the width at the position where the germanium semiconductor layer 500 comes into contact with the first region 110 including an intrinsic silicon semiconductor. The width w1 of the second region 120 may be greater than the width wc of the first conductive layer C1. The width w1 of the second region 120 may be greater than the width wc of the first conductive layer C1 and may be 3 times or less, or 2 times or less, of the width wc of the first conductive layer C1. However, the width w1 of the second region 120 is not limited thereto.

The thickness t1 of the second region 120 may be less than the thickness of an entirety of the first silicon semiconductor layer 100. The thickness ts of the first silicon semiconductor layer 100 may be a thickness based on the entire first silicon semiconductor layer 100 including the first region 110 and the second region 120, and as illustrated, may correspond to the thickness of a thick portion of the thickness of the first region 110. The thickness t1 of the second region 120 may be the same as the thickness ts of the first silicon semiconductor layer 100, or may be 50% or more, 95% or less, or 100% or less of the thickness of the first silicon semiconductor layer 100.

The second silicon semiconductor layer 200 may be arranged between the germanium semiconductor layer 500 and the substrate SU. The second silicon semiconductor layer 200 may be doped with a dopant having an opposite polarity to a polarity of the second region 120 of the first silicon semiconductor layer 100. The second silicon semiconductor layer 200 may include a first region 210 doped with a second conductivity type dopant and in contact with the germanium semiconductor layer 500, and a second region 220 and a third region 230 doped with a second conductivity type dopant at a higher doping concentration than a doping concentration of the first region 210. The second conductivity type dopant may be a p-type dopant. The p-type dopant may include B, Al, Ga, In, or Te. The second region 220 and the third region 230 may be provided to be in contact with opposite sides of the first region 210, respectively, and not in contact with the germanium semiconductor layer 500. The second conductive layer C2 may be disposed on the second region 220 of the second silicon semiconductor layer 200, and the third conductive layer C3 may be disposed on the third region 230 of the second silicon semiconductor layer 200.

One from among the second conductive layer C2 and the third conductive layer C3 may be omitted, and one from among the second region 220 and the third region 230 may be omitted.

The first conductive layer C1, the second conductive layer C2, and the third conductive layer C3 may each include a conductive material. The conductive material may include a metal, an alloy, a metal nitride, a silicide, and the like. The metal may include, for example, Au, Al, Ag, Cu, Pt, Ni, W, Ti, Mo, Ru, Ge, Ta, Hf, Nb, Zr, or V. The alloy may include, for example, AlNd. The metal nitride may include, for example, TiN, AlN, TaN, Ta₂N, Ta₃N₅, W₂N, WN, or WN₂. The silicide may include, for example, TiSi, TiSi₂, Ti₅Si₃, VSi₂, FeSi₂, CoSi₂, PtSi, Pt₂Si, NiSi, NiSi₂, Ni₂Si, Cu₃Si, YSi, ZrSi, NbSi₂, MoSi₂, PdSi, Pd₂Si, ErSi, YbSi, YbSi₂, ZrSi2, HfSi, HfSi₂, TaSi, TaSi₂, NbSi, NbSi₂, ZrSi, ZrSi₂, VSi, VSi₂, WSi, WSi₂, GeSi, OsSi, IrSi, IrSi₃, AlSi, CuSi RuSi, or Ru₂Si₃.

The second silicon semiconductor layer 200 may be a part of an optical waveguide that transmits light to the optical sensing element 1000. For example, the first region 210 may be an optical waveguide that transmits light in the Y direction. At least a portion of light travelling inside the optical waveguide in the Y direction may be coupled toward the germanium semiconductor layer 500 at a location adjacent to the optical sensing element 1000, for example, at a location adjacent to the germanium semiconductor layer 500, due to the difference in refractive index between the first region 210 and the germanium semiconductor layer 500. The coupling between the optical waveguide and the optical sensing element 1000 may be evanescent coupling or butt coupling.

If the energy of the light incident on the germanium semiconductor layer 500 is greater than the band gap energy of germanium Ge, a photocurrent may be generated with high efficiency by interband transition within the germanium semiconductor layer 500. The work function and energy level of the second region 120 and the first conductive layer C1 may be appropriately selected, so that a photocurrent can be generated with high quantum efficiency.

The optical sensing element 1000 may sense light in the infrared wavelength band. The optical sensing element 1000 may generate an electrical signal in response to light in the infrared wavelength band. The light in the infrared wavelength band may include light in the wavelength range used in the optical communication band such as, for example, light in a wavelength range of about 1,100 nm to about 1,600 nm. The germanium semiconductor layer 500 may be selected as a material suitable for detecting light in this wavelength band because, for example, light in the wavelength band described above may be difficult to detect with a silicon photodiode.

Germanium (Ge) may be grown on silicon, and accordingly, may be grown on a silicon substrate-based optical waveguide and applied to silicon photonics. However, germanium and silicon have different lattice constants, so there may be a lattice mismatch. The lattice mismatch is a cause in forming defects in the germanium semiconductor layer 500, which may cause noise due to dark current and reduce the photoresponsivity.

In this structure, if a process of injecting a dopant into the germanium semiconductor layer 500 is involved, defect sites are created in the germanium semiconductor layer 500, which increases the dark current. Furthermore, in the case of n-type dopants such as P or As, activation may be difficult because diffusion within Ge may be too fast. For this reason, photodiodes using a Ge p-n junction or a Ge p-i-n junction usually have a very high dark current, approximately in a range from about 10⁵ to about 10⁸ times greater than photodiodes on a silicon (Si) substrate.

In an embodiment of the disclosure, in order to reduce the dark current, a structure in which the defect in the germanium semiconductor layer 500 is minimized, may be employed. The germanium semiconductor layer 500 may not include a dopant, and the second region 120, which is a part of the first silicon semiconductor layer 100 formed on the upper surface of the germanium semiconductor layer 500 to protect the germanium semiconductor layer 500, may be doped and the width and thickness of the second region 120 may be set so that damage to the germanium semiconductor layer 500 does not occur during the doping process.

In other words, in the optical sensing element 1000 described above, the germanium semiconductor layer 500 may include an intrinsic germanium semiconductor that does not include a dopant, and the width, thickness, etc., of the second region 120 including doped silicon arranged adjacent thereto may be controlled, and thus, factors that cause defects, such as the injection of dopant into the germanium semiconductor layer 500 during the process of doping the silicon semiconductor material, may be minimized.

In the optical sensing element 1000 according to an embodiment, noise factors such as dark current may be reduced compared to a germanium semiconductor-based photodiode of a comparative embodiment.

FIG. 2 is a schematic cross-sectional view showing a structure of an optical sensing element 1001 according to an embodiment.

The optical sensing element 1001 may include a substrate SU, a second silicon semiconductor layer 201, a germanium semiconductor layer 500, and a first silicon semiconductor layer 101.

The optical sensing element 1001 according to an embodiment is different from the optical sensing element 1000 of FIG. 1 in that the second region 121 of the first silicon semiconductor layer 101, and the first region 211, the second region 221, and the third region 231 of the second silicon semiconductor layer 201 are doped with opposite polarities, and the remaining configuration may be substantially the same. That is, the conductivity type of the second region 121 of the first silicon semiconductor layer 101 may be p-type, and the conductivity types of the first region 211, the second region 221, and the third region 231 of the second silicon semiconductor layer 201 may be n-type. The p-type dopant may include B, Al, Ga, In, or Te, and the n-type dopant may include P, As, Sb, or Bi, and the like.

The optical sensing elements 1000 and 1001 of FIGS. 1 and 2 have a vertical type P-I-N structure, and in another embodiment, the optical sensing element may have a lateral type PI-N structure.

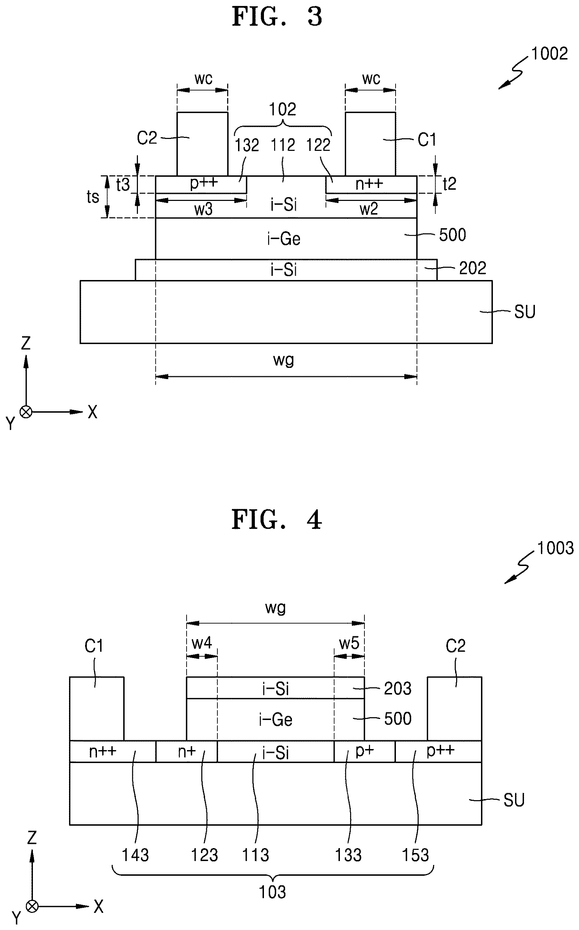

FIG. 3 is a schematic cross-sectional view showing the structure of an optical sensing element 1002 according to an embodiment.

The optical sensing element 1002 may include a substrate SU, a second silicon semiconductor layer 202, a germanium semiconductor layer 500, and a first silicon semiconductor layer 102.

The first silicon semiconductor layer 102 may be disposed on the germanium semiconductor layer 500. The first silicon semiconductor layer 102 may include a first region 112, a second region 122, and a third region 132. The first region 112 may be in contact with the germanium semiconductor layer 500 and may include an intrinsic silicon semiconductor. The second region 122 and the third region 132 may each include dopants of opposite polarities from each other. For example, the second region 122 may include silicon doped with a first conductivity type, and the third region 132 may include silicon doped with a second conductivity type. A first conductive layer C1 may be disposed on the second region 122, and a second conductive layer C2 may be disposed on the third region 132.

With respect to the description of a thickness t2 and width w2 of the second region 122, the description with respect to the thickness t1 and width w1 of the second region 120 of FIG. 1 may be similarly applied.

The description of the thickness t1 and width w1 of the second region 120 in the description of FIG. 1 may also be similarly applied to a thickness t3 and width w3 of the third region 132.

In other words, the second region 122 and the third region 132 may be high-concentration doping regions that form electrical contact and Schottky junction structures with the first conductive layer C1 and the second conductive layer C2, respectively, and the thicknesses and widths of the second region 122 and the third region 132 may be provided so as to minimize damage to the germanium semiconductor layer 500 during the doping process.

The width w2 of the second region 122 may be less than the width wg of the germanium semiconductor layer 500. The width w2 of the second region 122 may be less than the width wg of the first silicon semiconductor layer 102. The width w2 of the second region 122 may be greater than the width wc of the first conductive layer C1. The width w2 of the second region 122 may be greater than the width wc of the first conductive layer C1 and may be 3 times or less, or 2 times or less, of the width wc of the first conductive layer C1. However, embodiments of the disclosure are not limited thereto.

The thickness t2 of the second region 122 may be less than the thickness ts of the first silicon semiconductor layer 102. The thickness t2 of the second region 122 may be the same as the thickness of the first silicon semiconductor layer 102, or may be 50% or more, 100% or less, or 95% or less of the thickness ts of the first silicon semiconductor layer 102.

The width w3 of the third region 132 may be less than the width wg of the germanium semiconductor layer 500. The width w3 of the third region 132 may be less than the width wg of the first silicon semiconductor layer 102. The width w3 of the third region 132 may be greater than the width wc of the second conductive layer C2. The width w3 of the third region 132 may be greater than the width wc of the second conductive layer C2 and may be 3 times or less, or 2 times or less, of the width wc of the second conductive layer C2. However, embodiments of the disclosure are not limited thereto.

The thickness t3 of the third region 132 may be less than the thickness ts of the first silicon semiconductor layer 102. The thickness ts of the third region 132 may be equal to the thickness ts of the first silicon semiconductor layer 102, or may be 50% or more, 100% or less, or 95% or less of the thickness ts of the first silicon semiconductor layer 102.

The second silicon semiconductor layer 202 may be arranged between the substrate SU and the germanium semiconductor layer 500. The second silicon semiconductor layer 202 may include an intrinsic silicon semiconductor.

Similar to the description with reference to FIG. 1, the second silicon semiconductor layer 202 may be a part of a configuration forming an optical waveguide that transmits light to the optical sensing element 1002.

FIG. 4 is a schematic cross-sectional view showing the structure of an optical sensing element 1003 according to an embodiment.

The optical sensing element 1003 may include a substrate SU, a first silicon semiconductor layer 103, a germanium semiconductor layer 500, and a second silicon semiconductor layer 203.

The first silicon semiconductor layer 103 may be arranged between the substrate SU and the germanium semiconductor layer 500. The first silicon semiconductor layer 103 may include an intrinsic silicon semiconductor and may include a first region 113 that contacts the germanium semiconductor layer 500. The first silicon semiconductor layer 103 may also further include a second region 123, a third region 133, a fourth region 143, and a fifth region 153 that include a doped silicon semiconductor.

The second region 123 and the third region 133 may respectively be in contact with opposite sides of the first region 113, and may include silicon semiconductors doped with opposite conductivity type dopants from each other. The second region 123 may include a first conductivity type dopant, and the third region 133 may include a second conductivity type dopant. The first conductivity type may be n-type, and the second conductivity type may be p-type.

Only a portion of an upper surface of the second region 123 may be in contact with the germanium semiconductor layer 500. A width w4 of the portion of the second region 123 in contact with the germanium semiconductor layer 500 may be less than the width wg of the germanium semiconductor layer 500. The width w4 of the portion of the second region 123 in contact with the germanium semiconductor layer 500 may be greater than 0% and less than 50%, less than 40%, less than 30%, or less than 10% of the width wg of the germanium semiconductor layer 500.

The width w4 of the portion of second region 123 in contact with the germanium semiconductor layer 500 may be set to a portion of the entire width of the second region 123. For example, the width w4 of the portion of the second region 123 in contact with the germanium semiconductor layer 500 may be 70% or less or 50% or less of the entire width of the second region 123.

Only a portion of an upper surface of the third region 133 may be in contact with the germanium semiconductor layer 500. A width w5 of the portion of the third region 133 in contact with the germanium semiconductor layer 500 may be less than the width wg of the germanium semiconductor layer 500. The width w5 of the portion of the third region 133 in contact with the germanium semiconductor layer 500 may be greater than 0% and less than 50%, or less than 40%, or less than 30%, or less than 10% of the width wg of the germanium semiconductor layer 500.

The width w4 of the portion of the second region 123 in contact with the germanium semiconductor layer 500 may be set to 0%, and in some cases, the second region 123 and the germanium semiconductor layer 500 may not be in contact but may be separated (spaced apart). In this case, a width of the first region 113 of the first silicon semiconductor layer 103 may be greater than the width wg of the germanium semiconductor layer 500.

The width w5 of the portion of the third region 133 in contact with the germanium semiconductor layer 500 may be set as a portion of the entire width of the third region 133. For example, the width w5 of the third region 133 in contact with the germanium semiconductor layer 500 may be 70% or less or 50% or less of the entire width of the third region 133.

The width w5 of the third region 133 in contact with the germanium semiconductor layer 500 may be 0%, and in some cases, the third region 133 and the germanium semiconductor layer 500 may not be in contact but may be separated (spaced apart). In this case, the width of the first region 113 of the first silicon semiconductor layer 103 may be greater than the width wg of the germanium semiconductor layer 500.

The fourth region 143 may be laterally adjacent to the second region 123 and may include a silicon semiconductor doped with a first conductivity type dopant at a higher doping concentration than a doping concentration of the second region 123. The first conductive layer C1 may be disposed on the fourth region 143. The first conductive layer C1 may be formed to be in contact with the fourth region 143.

The fifth region 153 may be in contact with the third region 133 laterally and may include a silicon semiconductor doped with a second conductivity type dopant at a higher doping concentration than a doping concentration of the third region 133. The second conductive layer C2 may be disposed on the fifth region 153. The second conductive layer C2 may be formed to be in contact with the fifth region 153.

The second silicon semiconductor layer 203 may be disposed on the germanium semiconductor layer 500 and may be disposed to be in contact with the germanium semiconductor layer 500. The second silicon semiconductor layer 203 may include an intrinsic silicon semiconductor. The second silicon semiconductor layer 203 may be a layer protecting the germanium semiconductor layer 500. The second silicon semiconductor layer 203 may have a shape covering the germanium semiconductor layer 500 by extending to a side as well as an upper surface of the germanium semiconductor layer 500.

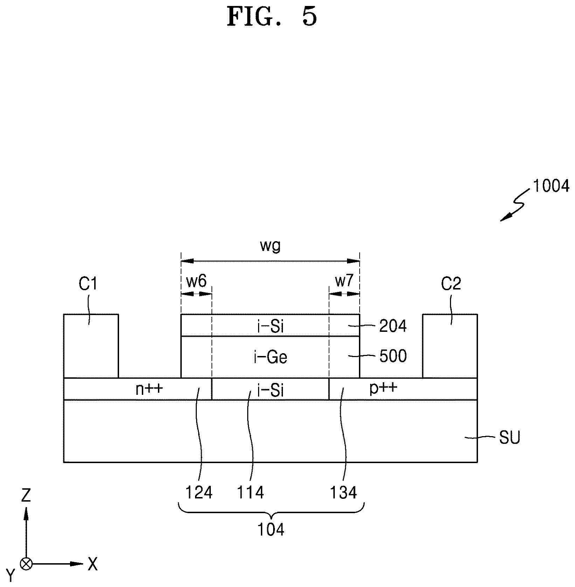

FIG. 5 is a schematic cross-sectional view showing the structure of an optical sensing element 1004 according to an embodiment.

The optical sensing element 1004 may include a substrate SU, a first silicon semiconductor layer 104, a germanium semiconductor layer 500, and a second silicon semiconductor layer 204.

The first silicon semiconductor layer 104 may be arranged between the substrate SU and the germanium semiconductor layer 500. The first silicon semiconductor layer 104 may include a first region 114 that includes an intrinsic silicon semiconductor and contacts the germanium semiconductor layer 500, a second region 124 that includes a silicon semiconductor doped with a first conductivity type dopant, and a third region 134 that includes a silicon semiconductor doped with a second conductivity type dopant.

The optical sensing element 1004 may differ from the optical sensing element 1003 of FIG. 4 in the division of the doping region of the first silicon semiconductor layer 104, and the remaining configuration may be substantially the same.

The descriptions of the widths w4 and w5 described with reference to FIG. 4 may be applied to widths w6 and w7, where the second region 124 and the third region 134 contact the germanium semiconductor layer 500, respectively, but is not limited to the same values as the values described with reference to the structure of FIG. 4.

The optical sensing elements 1000 to 1004 described with reference to FIGS. 1 to 5 have been described mainly with respect to the arrangement relationship of materials forming a p-in diode, and the detailed configurations of optical sensing elements of other embodiments of the disclosure may be modified into a structure that is easy to integrate with other components within an integrated circuit.

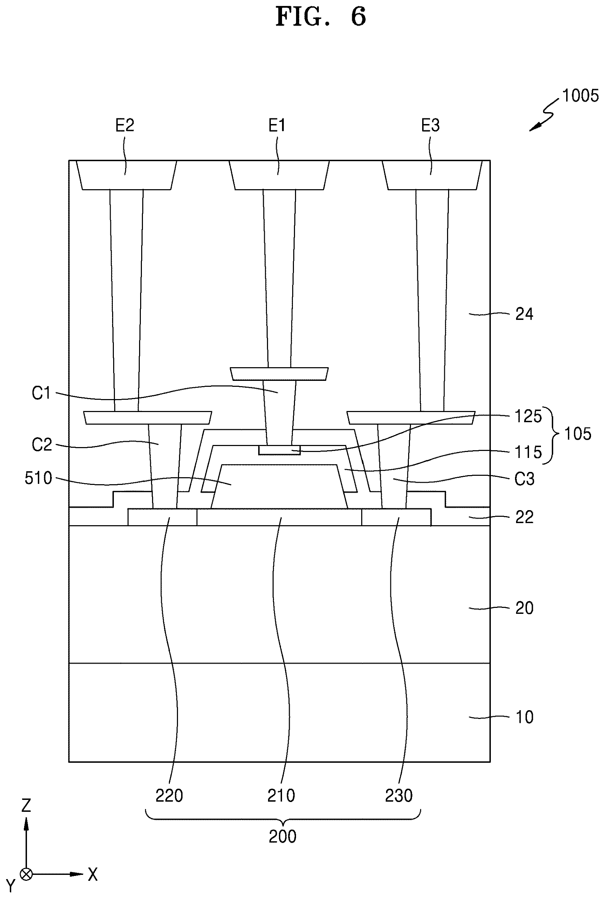

FIG. 6 is a schematic cross-sectional view showing the structure of an optical sensing element 1005 according to an embodiment.

The optical sensing element 1005 may include a second silicon semiconductor layer 200, a germanium semiconductor layer 510, and a first silicon semiconductor layer 105. The optical sensing element 1005 may also include a substrate 10 and an insulating layer 20, and the second silicon semiconductor layer 200, the germanium semiconductor layer 510, and the first silicon semiconductor layer 105 may be sequentially stacked on the insulating layer 20.

The first silicon semiconductor layer 105, the germanium semiconductor layer 510, and the second silicon semiconductor layer 200 may be similar to the first silicon semiconductor layer 100, the germanium semiconductor layer 500, and the second silicon semiconductor layer 200 provided in the optical sensing element 1000 described with reference to FIG. 1, respectively. The germanium semiconductor layer 510 may have a shape in which a width decreases in a growth direction, for example, the Z direction, and the shape is not limited thereto.

The substrate 10 may include silicon. The insulating layer 20 may include silicon oxide. The substrate 10, the insulating layer 20, and the second silicon semiconductor layer 200 may correspond to a lower silicon layer, silicon oxide, and upper silicon layer of an SOI substrate, respectively. That is, the second silicon semiconductor layer 200 may be formed by partially patterning the upper silicon layer of the SOI substrate and injecting a dopant, and depending on the doping concentration, a first region 210 having a relatively low concentration, a second region 220 and a third region 230, having a higher doping concentration than the first region 210, may be formed.

The first silicon semiconductor layer 105 may be arranged on the germanium semiconductor layer 510. The first silicon semiconductor layer 105 may have a cap shape that covers the entire upper surface and part of both side surfaces of the germanium semiconductor layer 510. The first silicon semiconductor layer 105 may include a first region 115 including an intrinsic silicon semiconductor, and a second region 125 doped with a first conductivity type dopant. The description of the second region 120 in FIG. 1 may be applied to the thickness and/or width of the second region 125.

The second silicon semiconductor layer 200, the germanium semiconductor layer 510, and the first silicon semiconductor layer 105 may be covered with an insulating material, and the first conductive layer C1 in contact with the first region 115 of the first silicon semiconductor layer 105, the second conductive layer C2 in contact with the second region 220 of the second silicon semiconductor layer 200, and the third conductive layer C3 in contact with the third region 230 of the second silicon semiconductor layer 200 may each have a form of a conductive via penetrating the insulating material or a form in which a conductive via and a conductive pad are combined. The first conductive layer C1, the second conductive layer C2, and the third conductive layer C3 may penetrate the insulating material and be connected to a first electrode E1, a second electrode E2, and a third electrode E3, respectively. The insulating material, as illustrated in FIG. 6, may include an insulating layer 22 and an insulating layer 24. The insulating layer 22 and the insulating layer 24 may include silicon oxide. However, embodiments of the disclosure are not limited thereto, and the insulating layer 22 and the insulating layer 24 may each independently include an insulating silicon compound or an insulating metal compound. The insulating silicon compound may include, for example, silicon nitride (SiₓN_{y}), silicon oxynitride (SiON), etc. The insulating layer 22 and the insulating layer 24 provided in a two-layer stacked structure may be provided according to convenience in the manufacturing process and is not limited to the illustrated form or number of layers.

An electrical signal generated in response to incident light may be measured through the first electrode E1, the second electrode E2, and the third electrode E3. A common voltage such as, for example, 0 V, may be applied to the second electrode E2 and the third electrode E3. The noise of an electrical signal may be reduced by applying a common voltage to the second region 220 and the third region 230 that are heavily doped, with the first region 210 that is lightly doped therebetween.

The optical sensing element 1005 may have a structure in which defects in the germanium semiconductor layer 510 that has a lattice constant difference from the silicon material may be minimized, and the electrical performance may be superior to that of a comparative example.

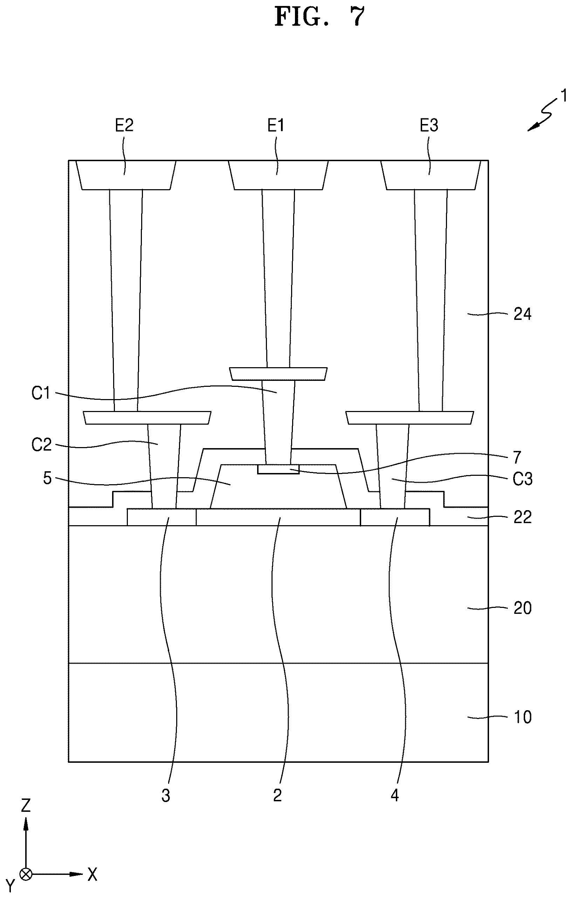

FIG. 7 is a schematic cross-sectional view showing the structure of an optical sensing element 1 according to the comparative example.

The optical sensing element 1 of the comparative example may include silicon semiconductor layers 2, 3, and 4, and a germanium semiconductor layer 5 formed on the silicon semiconductor layer 2. An upper region of the germanium semiconductor layer 5, that is, a contact region 7 in contact with the first conductive layer C1, includes germanium doped with a dopant. The contact region 7 may be formed by a process of injecting a dopant into a portion of an upper region of the germanium semiconductor layer 5 after forming the germanium semiconductor layer 5, and during this process, a defect may occur in the germanium semiconductor layer 5.

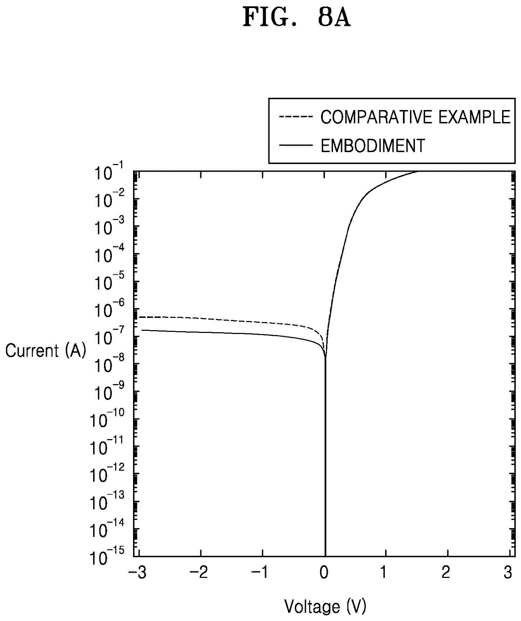

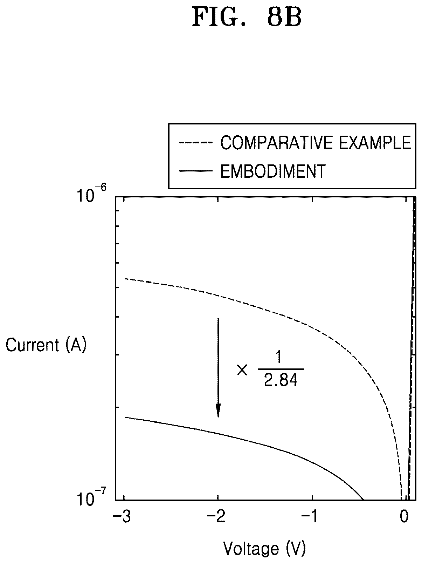

FIG. 8A is a graph comparing the dark current of the optical sensing element according to an embodiment and the optical sensing element according to the comparative example, and FIG. 8B is a graph showing an enlarged portion of FIG. 8A.

In the case of the embodiment, it may be seen that the dark current is less than the dark current of the comparative example, and is reduced by approximately 1/2.84 times compared to the dark current of the comparative example.

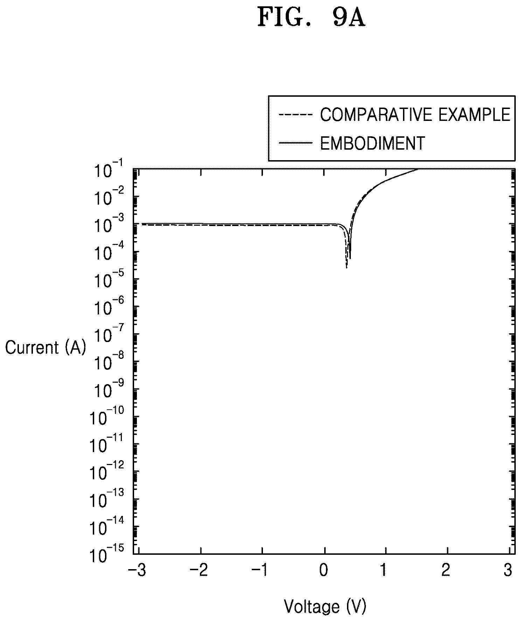

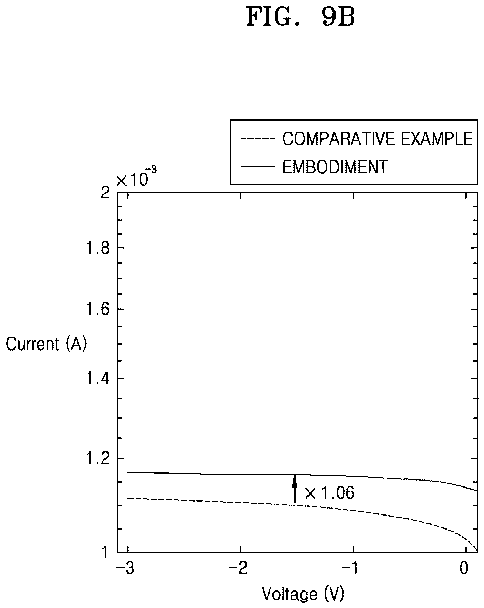

FIG. 9A is a graph comparing the photocurrent of the optical sensing element according to an embodiment and the optical sensing element according to the comparative example, and FIG. 9B is a graph showing an enlarged portion of FIG. 9A.

In the case of the embodiment, it may be seen that the photocurrent is greater than the photocurrent of the comparative example, and is increased by approximately 1.06 times.

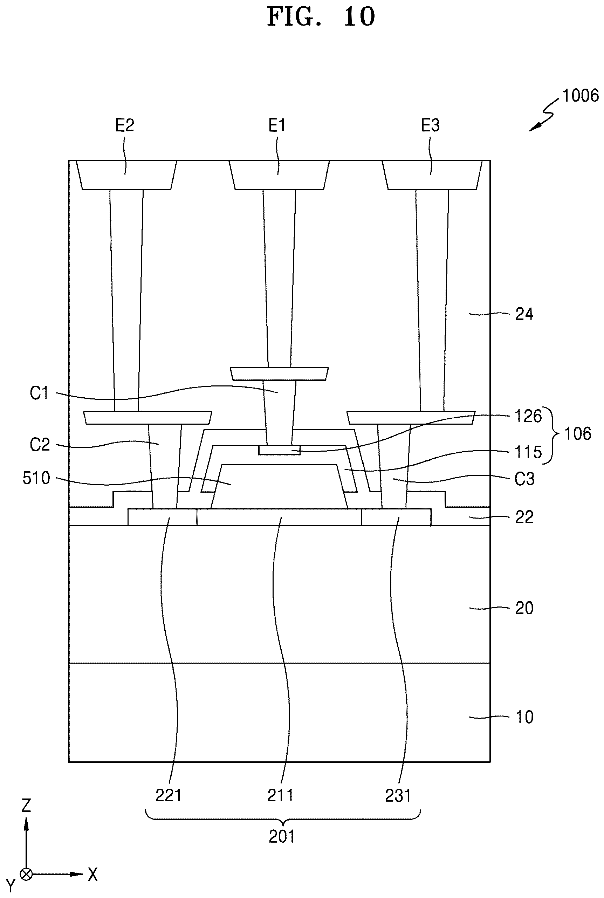

FIG. 10 is a schematic cross-sectional view showing the structure of an optical sensing element 1006 according to an embodiment.

The optical sensing element 1006 may include a second silicon semiconductor layer 201, a germanium semiconductor layer 510, and a first silicon semiconductor layer 106.

The optical sensing element 1006 according to an embodiment is different from the optical sensing element 1005 of FIG. 6 in that the polarities of a first region 211, a second region 221, and a third region 231 of the second silicon semiconductor layer a 201 and the polarity of the second region 126 of the first silicon semiconductor layer 106 are opposite to those of the optical sensing element 1005 of FIG. 6, and the remaining configuration is substantially the same.

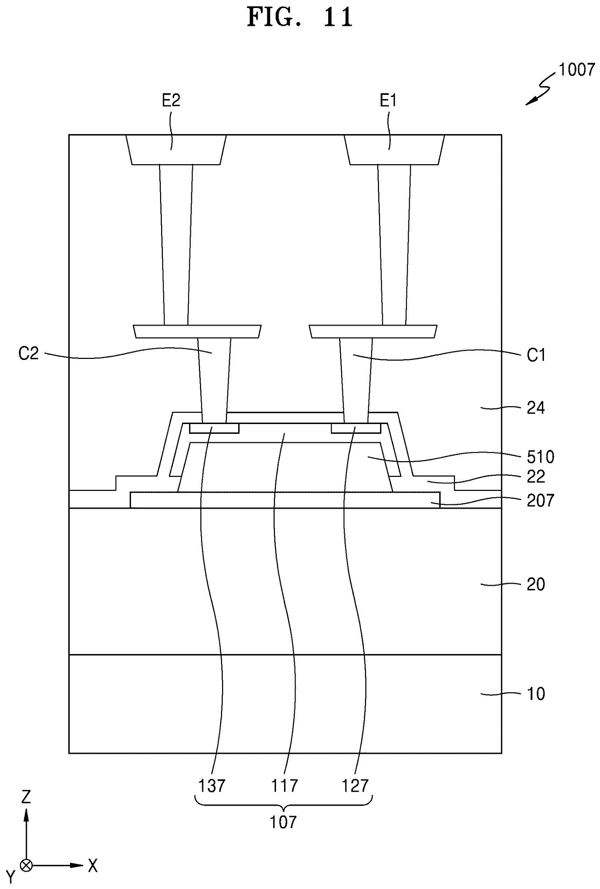

FIG. 11 is a schematic cross-sectional view showing the structure of an optical sensing element 1007 according to an embodiment.

The optical sensing element 1007 may include a second silicon semiconductor layer 207, a germanium semiconductor layer 510, and a first silicon semiconductor layer 107.

The second silicon semiconductor layer 207 may be arranged under the germanium semiconductor layer 510 and may include an intrinsic silicon semiconductor.

The first silicon semiconductor layer 107 may be arranged over the germanium semiconductor layer 510. The first silicon semiconductor layer 107 may have a cap shape that covers the entire upper surface and part of opposite side surfaces of the germanium semiconductor layer 510.

The first silicon semiconductor layer 107 may include a first region 117 that includes an intrinsic silicon semiconductor and contacts the germanium semiconductor layer 510, and a second region 127 and a third region 137 that include doped silicon semiconductors and include dopants of opposite polarities from each other. The second region 127 may be electrically connected to a first electrode E1 through the first conductive layer C1 that penetrates the insulating layer 22 and the insulating layer 24. The third region 137 may be electrically connected to a second electrode E2 through the second conductive layer C2 that penetrates the insulating layer 22 and the insulating layer 24.

With respect to descriptions of thickness and width of the second region 127 and the third region 137, the description given with respect to the second region 122 and the third region 132 of FIG. 3 may be applied.

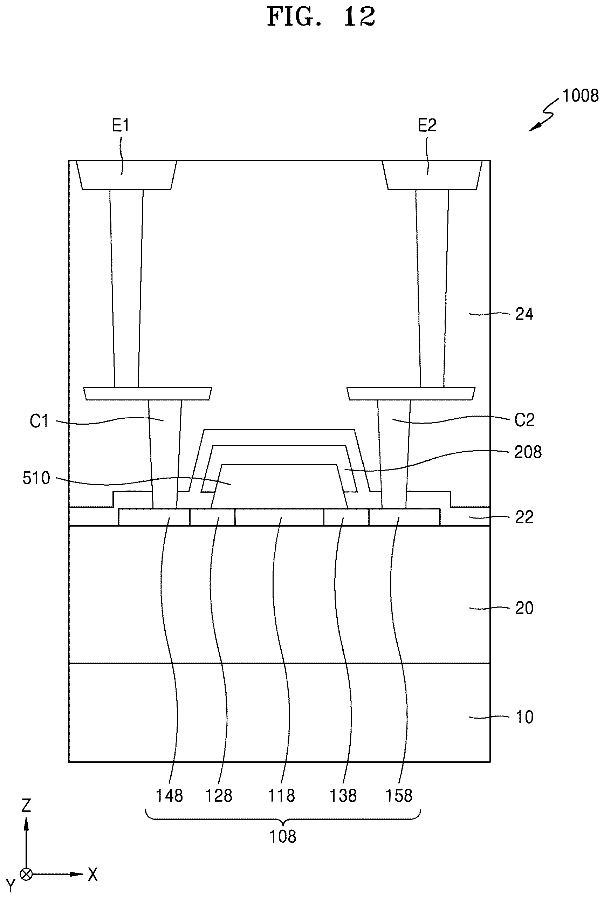

FIG. 12 is a schematic cross-sectional view showing the structure of an optical sensing element 1008 according to an embodiment.

The optical sensing element 1008 may include a first silicon semiconductor layer 108, a germanium semiconductor layer 510, and a second silicon semiconductor layer 208.

The second silicon semiconductor layer 208 may be disposed on the germanium semiconductor layer 510 and may include an intrinsic silicon semiconductor. The second silicon semiconductor layer 208 may have a cap shape that covers the entire upper surface and part of opposite side surfaces of the germanium semiconductor layer 510.

The first silicon semiconductor layer 108 may be disposed between the insulating layer 20 and the germanium semiconductor layer 510. The first silicon semiconductor layer 108 may include an intrinsic silicon semiconductor and may include a first region 118 that contacts the germanium semiconductor layer 510. The first region 118 may be in contact with the germanium semiconductor layer 510 as a whole. The first silicon semiconductor layer 108 may further include a second region 128, a third region 138, a fourth region 148, and a fifth region 158 that include doped silicon semiconductors.

The second region 128 and the third region138 may contact respective sides of the first region 118 and may each include silicon semiconductors doped with opposite conductivity type dopants. The second region 128 may include a first conductivity type dopant, and the third region 138 may include a second conductivity type dopant. The first conductivity type may be n-type, and the second conductivity type may be p-type.

The second region 128 and the third region 138 may be partially in contact with the germanium semiconductor layer 510, and the descriptions of the widths of the second region 123 and the third region 133 in FIG. 4 may be applied to widths of the second region 128 and the third region 138.

The fourth region 148 may be laterally adjacent to the second region 128 and may include a silicon semiconductor doped with a first conductivity type dopant at a greater doping concentration than a doping concentration of the second region 128. The fourth region 148 may be electrically connected to the first electrode E1 through the first conductive layer C1 penetrating the insulating layer 22 and the insulating layer 24.

The fifth region 158 may be laterally adjacent to the third region 138 and may include a silicon semiconductor doped with a second conductivity type dopant at a greater doping concentration than a doping concentration of the third region 138. The fifth region 158 may be electrically connected to the second electrode E2 through the second conductive layer C2 penetrating the insulating layer 22 and the insulating layer 24.

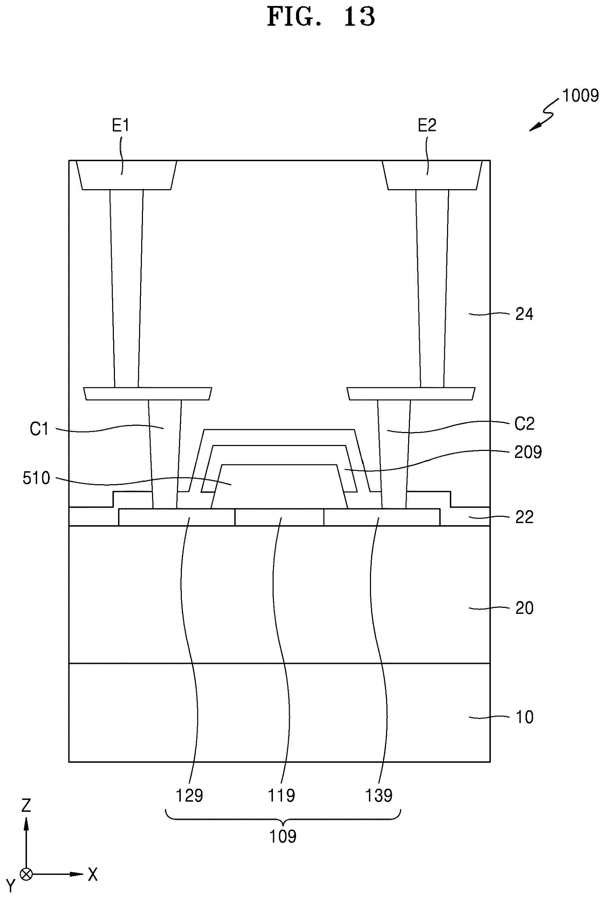

FIG. 13 is a schematic cross-sectional view showing the structure of an optical sensing element 1009 according to an embodiment.

The optical sensing element 1009 may include a first silicon semiconductor layer 109, a germanium semiconductor layer 510, and a second silicon semiconductor layer 209.

The second silicon semiconductor layer 209 may be arranged on the germanium semiconductor layer 510 and may include an intrinsic silicon semiconductor. The second silicon semiconductor layer 209 may have a cap shape that covers the entire upper surface and part of opposite side surfaces of the germanium semiconductor layer 510.

The first silicon semiconductor layer 109 may be arranged between the insulating layer 20 and the germanium semiconductor layer 510. The first silicon semiconductor layer 109 may include a first region 119 that includes an intrinsic silicon semiconductor and contacts the germanium semiconductor layer 510, a second region 129 that includes a silicon semiconductor doped with a first conductivity type dopant, and a third region 139 that includes a silicon semiconductor doped with a second conductivity type dopant.

The optical sensing element 1009 according to an embodiment differs from the optical sensing element 1008 of FIG. 12 in the division of the doping region of the first silicon semiconductor layer 109, and the remaining configuration is substantially similar to each other.

The description of the widths w6 and w7 described with reference to FIG. 5 may be applied to widths at which the second region 129 and the third region 139 contact the germanium semiconductor layer 510, respectively, but is not limited to the same values described with reference to the structure of FIG. 5.

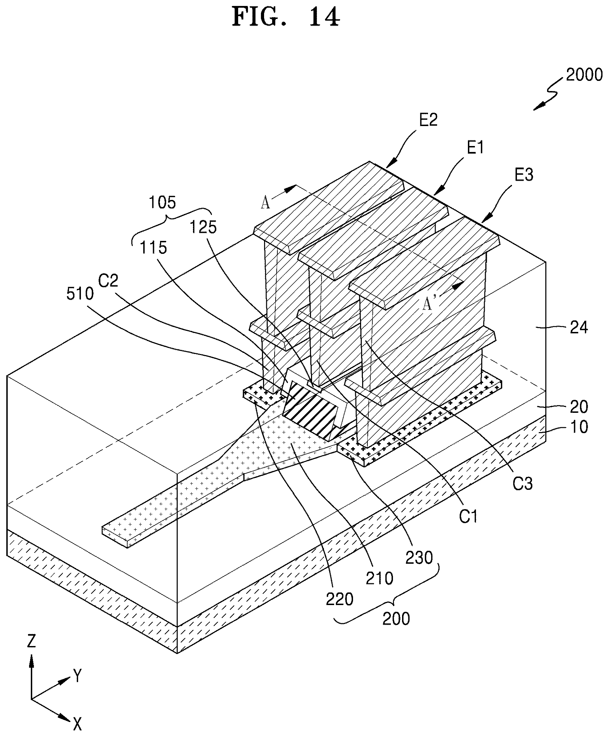

FIG. 14 is a schematic perspective view showing the structure of an optical integrated circuit 2000 according to an embodiment.

The optical integrated circuit 2000 may include a substrate 10, an insulating layer 20, a second silicon semiconductor layer 200, a germanium semiconductor layer 510, and a first silicon semiconductor layer 105.

FIG. 6 may be a portion of a cross-section of FIG. 14 along a line A-A' of FIG. 14. The optical integrated circuit 2000 may include an optical waveguide and an optical sensing element. The optical sensing element may be an optical sensing element as shown in FIG. 6.

The first silicon semiconductor layer 105 may include a first region 115 including an intrinsic silicon semiconductor, and a second region 125 including a silicon semiconductor doped with a first conductivity type dopant. The second region 125 may be in contact with a first conductive layer C1 and may be electrically connected to a first electrode E1 through the first conductive layer C1.

The second silicon semiconductor layer 200 may include a first region 210 including a silicon semiconductor doped with a second conductivity type dopant, and a second region 220 and a third region 230 doped with a second conductivity type dopant at a higher doping concentration than a doping concentration of the first region 210. The second region 220 and the third region 230 may be electrically connected to a second electrode E2 and a third electrode E3 through a second conductive layer C2 and a third conductive layer C3, respectively.

A part of the first region 210 may form an optical waveguide, and another part of the first region 210 may form an optical sensing element. A part of the first region 210 may form an optical waveguide and may also form an optical sensing element at the same time. This division of regions describes an optical function by the first region 210, and the division of regions does not limit the optical integrated circuit 2000 of the embodiment.

The first region 210 may extend in one direction (e.g., Y direction) and, as illustrated, may include a region having a constant first width, a region having a tapered shape with a gradually increasing width, and a third region maintaining a constant second width greater than the first width. This shape may be formed, for example, by patterning an upper silicon layer of an SOI substrate. Among portions of the first region 210, the region doped with the second conductivity type dopant may be a region extending from the end of the tapered shape with a gradually increasing width, i.e., a lower region of the germanium semiconductor layer 510. Among the portions of the first region 210, the region with a constant first width and the region with a tapered shape with a gradually increasing width may include a silicon semiconductor material and may not include a dopant.

Light may be totally reflected within the first region 210 and travel in the Y direction, and may be coupled toward the germanium semiconductor layer 510 at a location below the germanium semiconductor layer 510 where the total reflection condition is broken, for example, in the Z direction. In other words, light traveling along the first region 210, which is an optical waveguide, in the Y direction may be coupled to the germanium semiconductor layer 510 at the location of the first region 210, which is an optical sensing element. The coupled light may be detected as an electrical signal through the first electrode E1, the second electrode E2, and the third electrode E3 of the optical sensing element.

The optical integrated circuit 2000 may include other components, in addition to the optical waveguide and optical sensing elements, such as a light source, an optical amplifier, an optical modulator, or an optical coupler.

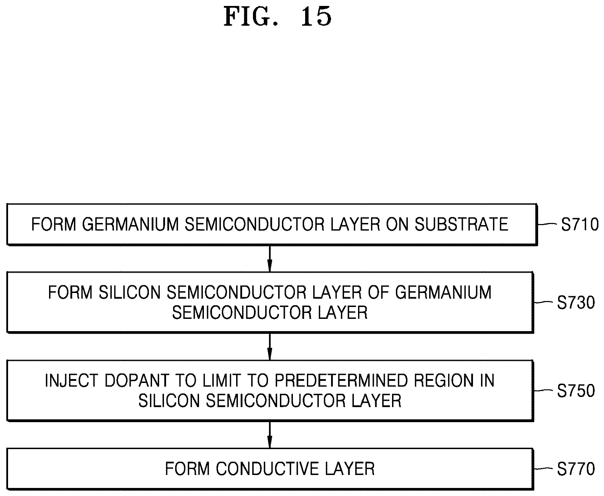

FIG. 15 is a flowchart for explaining a method of manufacturing an optical sensing element according to an embodiment.

The method of manufacturing an optical sensing element may include an operation of forming a germanium semiconductor layer on a substrate (operation S710), an operation of forming a silicon semiconductor layer covering the entire upper surface of the germanium semiconductor layer (operation S730), an operation of injecting a dopant limited to a predetermined region within the silicon semiconductor layer (operation S750), and an operation of forming a conductive layer in contact with the doped region (operation S770).

The operation of injecting a dopant limited to a predetermined region of the silicon semiconductor layer may be performed (operation S750) so as not to cause damage to the germanium semiconductor layer due to a doping process, and a width and a thickness of the predetermined region may be appropriately set. By controlling the doping concentration and energy, the width and thickness of the predetermined region to be doped may be controlled. When assuming that the thickness of the silicon semiconductor layer is t, a thickness t1 (or depth) (see FIG. 1) from an upper surface of the silicon semiconductor layer, into which the dopant is injected, may be t or less, or 0.5t or more, or 0.95t or more, or 1.0t or less. The width of the predetermined region may be less than the width of the germanium semiconductor layer and greater than the width of the conductive layer formed on the predetermined region.

According to the manufacturing method described above, various example optical sensing elements and optical integrated circuits described above may be manufactured.

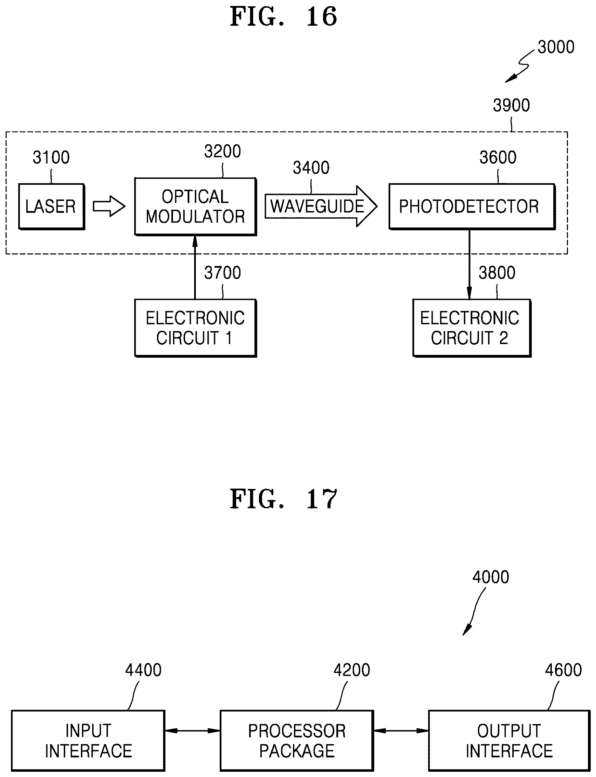

FIG. 16 is a block diagram showing a schematic structure of an optical integrated circuit according to an embodiment.

The optical integrated circuit 3000 may include a light source 3100, an optical waveguide 3400 that transmits light from the light source 3100, and a photodetector 3600 that converts light transmitted through the optical waveguide 3400 into an electrical signal. The photodetector 3600 may include any one from among the aforementioned optical sensing elements 1000 to 1009 or a modified structure thereof.

This structure may be, for example, a part of a circuit forming an optical transceiver. The optical integrated circuit 3000 may further include the light source 3100, an optical modulator 3200 arranged in the optical waveguide 3400, a first electronic circuit 3700 that applies a modulation signal to the optical modulator 3200, and a second electronic circuit 3800 that transmits an electrical signal converted by the photodetector 3600. A coupler may be arranged between the light source 3100, the optical modulator 3200, the optical waveguide 3400, and the photodetector 3600, and in addition, a passive circuit, an isolator, a duplexer, a splitter, a filter, and the like may further be included.

The light source 3100, the optical modulator 3200, the optical waveguide 3400, and the photodetector 3600 may be placed on a same substrate 3900. The substrate 3900 may include a silicon substrate. The photodetector 3600 may have a configuration utilizing germanium based on silicon.

The light source 3100 may be, for example, a laser that emits light in a wavelength band in a range from about 800 nm to about 1700 nm. In order to sense light in this wavelength band and convert the light into an electrical signal, a photodiode based on a Group III-V semiconductor may be used, but the forming the photodiode on a silicon substrate requires a high process difficulty and cost. As in the embodiment, by applying a silicon/germanium-based photodiode that may sense light in the wavelength band described above and may be implemented with a stable process to the photodetector 3600, an optical integrated circuit 3000 that may utilize the advantages of silicon photonics, such as large-capacity information transmission, ultra-high-speed processing, minimal transmission loss, and energy consumption reduction may be implemented.

FIG. 17 is a block diagram showing a schematic structure of an electronic device 4000 according to an embodiment.

The electronic device 4000 may include a processor package 4200, an input interface 4400, and an output interface 4600. The input interface 4400 and the output interface 4600 may be electrically connected to the processor package 4200. The processor package 4200 may include a processor and an optical integrated circuit. The optical integrated circuit may include any one from among the optical sensing elements 1000 to 1009 described above, or an optical sensing element having a structure in which these elements are modified or combined.

The optical sensing elements described above may have a structure in which damage to a germanium semiconductor layer that may occur during a manufacturing process may be minimized.

By the optical sensing elements described above, dark current may be reduced and the detection efficiency of photocurrent may be increased.

Optical sensing elements, a manufacturing method, and electronic devices have been described above with reference to example embodiments illustrated in the drawings, but it will be understood by those of ordinary skill in the art that various changes in form and details may be made therein without departing from the scope of the disclosure. Therefore, the example embodiments should be considered in descriptive sense only and not for purposes of limitation.

Embodiments described herein should be considered in a descriptive sense only and not for purposes of limitation. Descriptions of features or aspects within each embodiment of the disclosure should typically be considered as available for other similar features or aspects in other embodiments of the disclosure. While one or more example embodiments have been described with reference to the figures, it will be understood by those of ordinary skill in the art that various changes in form and details may be made therein without departing from the scope of the disclosure.

## Claims

1. An optical sensing element comprising:
a substrate;
a first silicon semiconductor layer on the substrate in a first direction;
a second silicon semiconductor layer on the substrate in the first direction, and spaced apart from the first silicon semiconductor layer in the first direction; and
a germanium semiconductor layer between the first silicon semiconductor layer and the second silicon semiconductor layer, the germanium semiconductor layer comprising germanium,
wherein the first silicon semiconductor layer comprises:
a first region comprising an intrinsic silicon semiconductor,
a second region comprising a silicon semiconductor doped with a first conductivity type dopant, and
wherein the germanium semiconductor layer comprises an intrinsic germanium semiconductor, and an entirety of the intrinsic germanium semiconductor of the germanium semiconductor layer does not include a dopant.

2. The optical sensing element of claim 1, wherein
the first region of the first silicon semiconductor layer is in contact with the germanium semiconductor layer in the first direction, and
the second silicon semiconductor layer is between the substrate and the germanium semiconductor layer.

3. The optical sensing element of claim 1 or 2, wherein the second silicon semiconductor layer is doped with a second conductivity type dopant, which is opposite to a conductivity type of the first conductivity type dopant.

4. The optical sensing element of any one of the previous claims, further comprising:
a first conductive layer on the first silicon semiconductor layer and comprising a conductive material,
wherein the second region of the first silicon semiconductor layer is between the first region of the first silicon semiconductor layer and the first conductive layer, and the second region of the first silicon semiconductor layer is in contact with the first conductive layer.

5. The optical sensing element of any one of the previous claims, wherein a width of the second region of the first silicon semiconductor layer in a second direction crossing the first direction is less than a width of the germanium semiconductor layer in the second direction; and/or
wherein a thickness of the second region of the first silicon semiconductor layer in the first direction is less than or equal to a total thickness of the first silicon semiconductor layer in the first direction, wherein preferably the thickness of the second region of the first silicon semiconductor layer is 50 % to 100 % of the total thickness of the first silicon semiconductor layer.

6. The optical sensing element of any one of the previous claims, wherein the second silicon semiconductor layer comprises:
a first region in contact with the germanium semiconductor layer; and
a second region adjacent to the first region of the second silicon semiconductor layer, the second region of the second silicon semiconductor layer having a higher doping concentration than a doping concentration of the first region of the second silicon semiconductor layer.

7. The optical sensing element of claim 4 and claim 6, further comprising:
a second conductive layer in contact with the second region of the second silicon semiconductor layer in the first direction, the second conductive layer comprising a conductive material.

8. The optical sensing element of any one of the previous claims, wherein the second silicon semiconductor layer comprises an intrinsic silicon semiconductor layer.

9. The optical sensing element of any one of the previous claims, wherein
the first silicon semiconductor layer further comprises a third region comprising a silicon semiconductor doped with a second conductivity type dopant having a conductivity type opposite to a conductivity type of the first conductivity type dopant,
wherein preferably a thickness of the second region of the first silicon semiconductor layer in the first direction and a thickness of the third region of the first silicon semiconductor layer in the first direction are less than or equal to a thickness of the first silicon semiconductor layer in the first direction.

10. The optical sensing element of claim 4 and 9, wherein
the first conductive layer is on the first silicon semiconductor layer in the first direction; further comprising:
a second conductive layer on the first silicon semiconductor layer in the first direction, the second conductive layer spaced apart from the first conductive layer in a second direction crossing the first direction,
wherein the second conductive layer comprises a conductive material,
wherein the third region of the first silicon semiconductor layer is in contact with the second conductive layer, and is between the second conductive layer and the first region of the first silicon semiconductor layer;

11. The optical sensing element of claim 9, wherein
the first region of the first silicon semiconductor layer is between the second region of the first silicon semiconductor layer and the third region of the first silicon semiconductor layer in a second direction crossing the first direction;
wherein preferably the first silicon semiconductor layer further comprises:
a fourth region adjacent to the second region and doped with the first conductivity type dopant at a higher concentration than a doping concentration of the second region; and
a fifth region adjacent to the third region and doped with the second conductivity type dopant at a higher concentration than a doping concentration of the third region.

12. The optical sensing element of any one of the previous claims, wherein
the first silicon semiconductor layer or the second silicon semiconductor layer forms a part of an optical waveguide extending in a direction crossing to the first direction.

13. An optical integrated circuit comprising:
an optical waveguide; and
an optical sensing element according to any one of the claims 1-12, configured to couple light traveling along the optical waveguide to generate an electrical signal corresponding to the light.

14. An electronic device comprising:
a processor package comprising an optical integrated circuit and a processor;
an input interface electrically connected to the processor package; and
an output interface electrically connected to the processor package,
wherein the optical integrated circuit comprises the optical sensing element of any one of the claims 1-12.

15. A method of manufacturing an optical sensing element, comprising:
forming an intrinsic germanium semiconductor layer on a substrate;
forming a silicon semiconductor layer that covers an entire upper surface of the intrinsic germanium semiconductor layer;
forming a doped silicon semiconductor region in the silicon semiconductor layer by injecting a dopant into the silicon semiconductor layer, wherein the doped silicon semiconductor region has a thickness from an upper surface of the silicon semiconductor layer, and the thickness of the doped silicon semiconductor region is less than an entire thickness of the silicon semiconductor layer; and
forming a conductive layer, wherein the conductive layer is in contact with the doped silicon semiconductor region.
